# FASCICULE DE BREVET EUROPEEN

(11) **EP 4 026 221 B1**
(45) Date de publication et mention de la délivrance du brevet: **02.12.2026**
(21) Numéro de dépôt: 20761612.9
(22) Date de dépôt: 01.09.2020
(51) Int. Cl.: H02J 7/54

(54) **PROCEDE DE GESTION DE FONCTIONNEMENT DE BATTERIE**
VERFAHREN ZUR VERWALTUNG DES BETRIEBS EINER BATTERIE
METHOD FOR MANAGING THE OPERATION OF A BATTERY

(30) Priorité: 03.09.2019 FR 1909700
(43) Date de publication de la demande: 13.07.2022
(73) Titulaire: SEB S.A., 69130 Ecully (FR)
(72) Inventeur: CROZE, Arthur, 38200 VIENNE (FR); GAILHARD, Thierry, 69970 CHAPONNAY (FR); MAZIERE, Hervé, 73630 LE CHATELARD (FR)
(74) Mandataire: SEB Développement
(86) Numéro de dépôt international: PCT/EP2020/074303
(87) Numéro de publication internationale: WO 2021/043749

(56) Documents cités:
- US-A1- 2007 182 377
- US-A1- 2013 162 259
- US-A1- 2019 148 701

## Description

### Domaine de l'invention

La présente invention concerne un procédé de gestion de fonctionnement de batterie, en particulier lors de la charge et/ou de la décharge de batterie. La présente invention concerne également un dispositif de gestion de fonctionnement de batterie.

### Art antérieur

Une batterie comprend une pluralité de cellules qui peuvent être raccordées en série et/ou en parallèle. Chaque cellule présente à ses bornes une tension qui lui est propre et qui peut varier lors de la charge et/ou de la décharge.

Pour des raisons de sécurité et pour ne pas endommager la batterie, la tension aux bornes de chaque cellule ne doit pas dépasser une tension maximale de charge et ne doit pas être inférieure à une tension minimale de charge.

Il est ainsi important de pouvoir mesurer avec précision les tensions des cellules lors de la charge et de la décharge de la batterie pour s'assurer que ces tensions sont comprises entre la tension minimale de décharge et la tension maximale de charge.

Cette surveillance permet d'une part de signaler à l'utilisateur que la batterie est déchargée et d'autre part de stopper la charge lors de la recharge de la batterie. Exemples de structures de surveillance peuvent être trouvés dans le document US2013162259.

Des puces analogiques peuvent être utilisées pour contrôler individuellement les tensions des cellules, chaque puce analogique étant raccordée aux bornes d'une cellule.

Un module spécifique, tel qu'un module AFE ou « analog front-end » en anglais, raccordant la pluralité de cellules à une unité de contrôle, peut également être utilisé.

Ces agencements donnent satisfaction en ce que la tension de chaque cellule peut être surveillée. Cependant, ces agencements s'avèrent complexes à configurer, couteux et sont limités à une batterie avec un nombre de cellules spécifié par le fabricant.

La présente invention vise à résoudre tout ou partie des inconvénients mentionnés ci-dessus.

### Exposé de l'invention

A cet effet, la présente invention concerne un procédé de gestion de fonctionnement de batterie pour une charge et/ou une décharge d'une batterie, la batterie comprenant une pluralité de cellules, le procédé étant mis en oeuvre par une unité de contrôle, l'unité de contrôle comprenant un microcontrôleur, une mémoire associée au microcontrôleur et un convertisseur analogique-numérique, le convertisseur analogique-numérique comprenant des entrées, chaque entrée étant reliée à une branche de circuit comprenant un pont diviseur de tension dont une borne est reliée à la masse de l'unité de contrôle (UC) et connectant ladite entrée à une borne d'une cellule de la batterie, le convertisseur analogique-numérique comprenant au moins une sortie, l'au moins une sortie étant configurée pour délivrer une pluralité de signaux de sortie correspondant à chacune des entrées, le procédé comprenant des étapes suivantes :
- collecte par le microcontrôleur d'une pluralité de signaux de sortie du convertisseur analogique-numérique, chaque signal de sortie donnant une valeur représentative d'un potentiel de l'entrée correspondante du convertisseur analogique-numérique,
- pour chaque signal de sortie, lecture de paramètres de calibration dans la mémoire de l'unité de contrôle, les paramètres de calibration dépendant de caractéristiques intrinsèques d'une part de la branche de circuit correspondante et d'autre part du convertisseur analogique-numérique, le convertisseur analogique-numérique reliant lesdites entrées à l'au moins une sortie du convertisseur analogique-numérique,
- obtention, à partir de chaque valeur représentative, d'une valeur représentative corrigée par correction de la valeur représentative collectée en prenant en compte les paramètres de calibration correspondants, la valeur représentative corrigée correspondant à une valeur calculée d'un potentiel de la borne correspondante de la cellule,
- détermination, pour chaque cellule, d'une valeur de tension calculée aux bornes de la cellule correspondante, ladite détermination prenant en compte les valeurs représentatives corrigées correspondant aux bornes de ladite cellule.

Cette disposition permet d'obtenir une mesure précise de la tension aux bornes de chaque cellule en utilisant un nombre limité de composants.

Selon un aspect de l'invention, le microcontrôleur est agencé pour lire la pluralité de signaux de sortie sur l'au moins une sortie par multiplexage.

Selon un mode de réalisation, les paramètres de calibration prennent en compte une correspondance entre des valeurs comprises dans une plage de tensions d'entrée et des valeurs de signaux de sortie correspondants du convertisseur analogique-numérique.

Selon un aspect de l'invention, la mémoire associée au microcontrôleur est de type non volatile. De préférence, ladite mémoire est une mémoire morte, en particulier de type EEPROM.

Dans le présent texte, il est entendu par « potentiel » une différence de potentiels entre l'entité concernée et une masse de l'unité de contrôle.

Selon un aspect de l'invention, les cellules sont raccordées électriquement en série et le convertisseur analogique-numérique comprend plusieurs entrées, deux entrées consécutives correspondant aux deux bornes d'une cellule, au moins une entrée desdites deux entrées correspondant à une borne commune à deux cellules attenantes.

Ainsi, deux cellules attenantes sont raccordées à une entrée correspondante.

Selon un aspect de l'invention, lors de la charge de la batterie, les étapes suivantes sont également réalisées :
- comparaison des valeurs de tensions calculées relatives aux cellules à au moins une valeur de tension limite prédéterminée correspondante,
- génération par l'unité de commande d'un signal d'arrêt de la charge de la batterie lorsqu'au moins une des valeurs de tension calculée atteint l'au moins une valeur de tension limite prédéterminée correspondante.

En d'autres termes, la charge de la batterie correspond à l'application d'une source d'énergie électrique aux bornes de la batterie. Les cellules étant montées en série, la source d'énergie électrique est connectée aux cellules de manière à ce que l'ensemble des cellules soit alimenté par la source d'énergie électrique.

Le fait de déterminer la valeur de tension calculée de chaque cellule permet de détecter la cellule qui arrive en fin de charge en premier et ainsi d'arrêter le chargement pour ne pas endommager la batterie. La fiabilité et la durée de vie de la batterie sont donc assurées. La charge est également sécurisée.

Selon un aspect de l'invention, lors de la décharge de la batterie, les étapes suivantes sont également réalisées :
- comparaison des valeurs de tensions calculées relatives aux cellules à au moins une valeur de tension minimale de fonctionnement prédéterminée correspondante,
- génération par l'unité de commande d'un signal d'arrêt de décharge de la batterie lorsqu'au moins une valeur de tension calculée atteint l'au moins une valeur de tension minimale de fonctionnement prédéterminée correspondante.

En d'autres termes, la décharge de la batterie correspond à l'utilisation de la batterie comme générateur.

Le fait de déterminer la valeur de tension calculée de chaque cellule permet de détecter la cellule qui arrive en fin de décharge ne pouvant plus fournir une tension suffisante et ainsi d'avertir l'utilisateur de cette situation. L'utilisateur connait donc en temps réel l'état de sa batterie, c'est-à-dire sa capacité à fonctionner normalement comme générateur.

Selon un aspect de l'invention, les paramètres de calibration prennent en compte un facteur de division entre le potentiel d'une borne d'une cellule et le potentiel de l'entrée correspondante du convertisseur analogique-numérique.

Selon un aspect de l'invention, le facteur de division est obtenu par un pont diviseur de tension d'une pluralité de ponts diviseurs de tension de l'unité de contrôle. Chaque pont diviseur de tension est disposé entre une cellule et une entrée correspondante du convertisseur analogique-numérique et comprend de préférence deux résistances dont une est en particulier reliée à la masse de l'unité de contrôle. De préférence, la deuxième résistance est comprise dans la branche de circuit correspondante.

Selon un aspect de l'invention, un dispositif d'équilibrage à courant de fuite provoque des courants de fuite entre les cellules de façon à équilibrer les courants circulant dans chaque cellule, le dispositif d'équilibrage à courant de fuite comprenant une pluralité de résistances, chaque résistance étant connectée parallèlement à une cellule correspondante.

Selon un aspect de l'invention, chaque résistance est disposée entre un pont diviseur et une cellule correspondante.

De préférence, chaque résistance présente une forte impédance de manière à restreindre les courants de fuite.

Selon un aspect de l'invention, le procédé de gestion de fonctionnement de batterie comprend une étape préalable de détermination du nombre de cellules de la batterie, les paramètres de calibration étant fonction du nombre de cellules.

Cette disposition permet de déterminer quel type de batterie est utilisé et ainsi de sélectionner les paramètres de calibration correspondants.

Selon un aspect de l'invention, les paramètres de calibration sont déterminés lors d'une phase de calibration préalable à l'étape de lecture relative à la branche de circuit correspondante, la phase de calibration préalable comprenant les étapes suivantes :
- application de valeurs de potentiels de référence en lieu et place des bornes des cellules,
- collecte par le microcontrôleur d'une pluralité de signaux de sortie de calibration du convertisseur analogique-numérique, chaque signal de sortie donnant une valeur représentative d'un potentiel sur l'entrée correspondante du convertisseur analogique-numérique,
- détermination des paramètres de calibration en fonction des valeurs de potentiels de référence et de signaux de sortie de calibration correspondants.

Ainsi les paramètres de calibration sont déterminés en prenant en compte l'effet du convertisseur analogique-numérique et de la branche de circuit correspondante sur le signal de sortie.

Selon un aspect de l'invention, la phase de calibration comprend une étape additionnelle d'enregistrement en mémoire de l'unité de contrôle des paramètres de calibration.

Cette calibration permet ainsi de définir une correspondance entre les potentiels d'entrée et la tension calculée de manière simple. En effet, une seule phase de calibration est nécessaire en sortie d'usine car la correspondance entre signal de sortie et tension calculée est enregistrée.

Selon un aspect de l'invention, l'étape additionnelle d'enregistrement est réalisée une seule fois avant la première mise en service de la batterie.

Selon un aspect de l'invention, pour chaque entrée, l'étape d'application d'une valeur de potentiel de référence et l'étape de collecte par le microcontrôleur d'un signal de sortie de calibration correspondant sont réalisés deux fois de façon à obtenir un premier signal de sortie de calibration et un deuxième signal de sortie de calibration par entrée en fonction, respectivement, d'une première valeur de potentiel de référence et d'une deuxième valeur de potentiel de référence et dans lequel l'étape de détermination des paramètres de calibration prend en compte, pour chaque entrée, le premier signal de sortie de calibration et le deuxième signal de sortie de calibration relativement à la première valeur de potentiel de référence et la deuxième valeur de potentiel de référence.

Cette disposition permet d'obtenir les paramètres de calibration à partir de deux mesures seulement.

Selon un aspect de l'invention, la première valeur de potentiel de référence correspond à une tension maximale de charge et la deuxième valeur de potentiel de référence correspond à une tension minimale de décharge.

Selon un aspect de l'invention, la tension maximale de charge est de 4,2V +/- 30mV et la tension minimale de décharge est de 2,7V+/- 30mV.

Selon un aspect de l'invention, les paramètres de calibration comprennent une valeur de décalage en tension et une valeur de gain en tension.

Selon un aspect de l'invention, le procédé de gestion de fonctionnement de batterie comprend une étape de sélection et d'enregistrement en mémoire de l'unité de contrôle du nombre de cellules de la batterie.

Selon un aspect de l'invention, l'étape de sélection et d'enregistrement est réalisée préalablement à l'étape d'application d'une valeur de potentiel de référence en lieu et place de la cellule correspondante. Cette disposition permet de choisir le potentiel de référence adéquat.

Selon un aspect de l'invention, les étapes dudit procédé sont réalisées à plusieurs reprises pour des batteries de différents nombres de cellules.

Cette disposition permet de réaliser un étalonnage valable pour plusieurs types de batteries, c'est-à-dire des batteries comprenant plus ou moins de cellules. Ainsi, à chaque type de batterie correspond des paramètres de calibration.

La présente invention concerne également un dispositif de gestion de fonctionnement de batterie pour surveiller une charge et/ou une décharge d'une batterie comprenant une pluralité de cellules configuré pour exécuter un procédé de gestion tel que décrit ci-avant.

Selon un aspect de l'invention, le dispositif de gestion de fonctionnement de batterie comprend une unité de contrôle telle que décrite ci-avant et une pluralité de branches de circuits.

Selon un aspect de l'invention, chaque branche de circuit est configurée pour être raccordée électriquement d'une part à une borne d'une cellule de la pluralité de cellules et d'autre part à une entrée correspondante du convertisseur analogique numérique de l'unité de contrôle.

Les différents aspects définis ci-dessus non incompatibles peuvent être combinés.

### Brève description des figures

L'invention sera mieux comprise à l'aide de la description détaillée qui est exposée ci-dessous en regard des dessins annexés.
La figure 1 est une vue schématique d'une batterie et d'un dispositif de gestion de fonctionnement de batterie.
La figure 2 est un schéma représentant les étapes d'un procédé de gestion de fonctionnement de batterie.

### Description en référence aux figures

Dans la description détaillée qui va suivre des figures définies ci-dessus, les mêmes éléments ou les éléments remplissant des fonctions identiques pourront conserver les mêmes références de manière à simplifier la compréhension de l'invention.

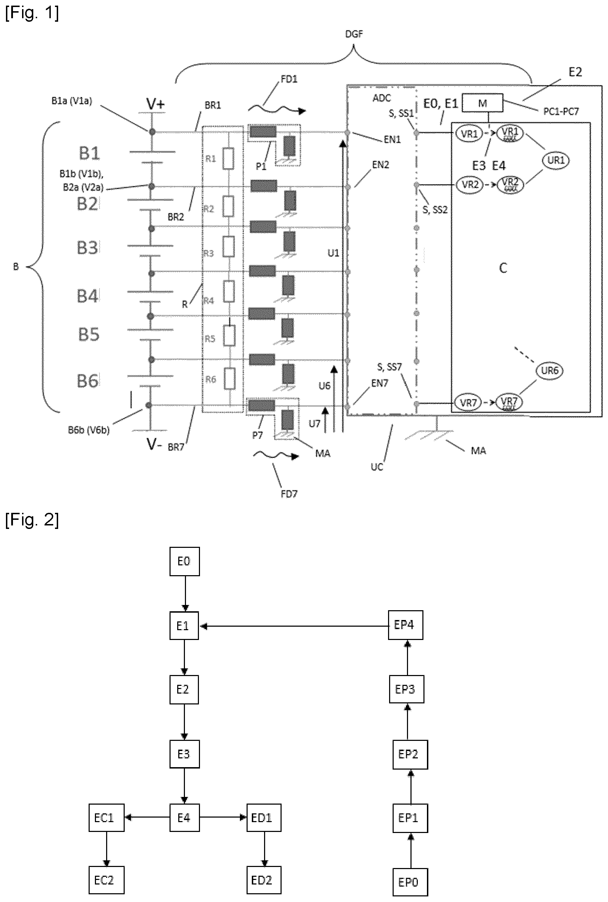

Comme illustré à la figure 1, un dispositif de gestion de fonctionnement de batterie DGF comprend une unité de contrôle UC et une pluralité de branches de circuit BR1-BR7 comprenant chacune un pont diviseur de tension P1-P7.

L'unité de contrôle UC comprend un microcontrôleur C, une mémoire M et un convertisseur analogique numérique ADC. La mémoire M est non volatile de type EEPROM.

Le convertisseur analogique numérique ADC comprend une pluralité d'entrées EN1-EN7 et au moins une sortie S, l'au moins une sortie S étant raccordée au microcontrôleur C.

Le dispositif de gestion de fonctionnement de batterie DGF est raccordé à une batterie B comprenant une pluralité de cellules B1-B6 raccordées entre elles en série.

Chaque branche de circuit BR1-BR7 relie une borne B1a-B6b d'une cellule B1-B6 correspondante à une entrée EN1-EN7 correspondante.

Certaines entrées EN2-EN6 sont raccordées à des bornes B1b-B6a communes à deux cellules B1-B6 attenantes.

Les paramètres de calibration PC1-PC7 prennent en compte un facteur de division FD1-FD7 entre le potentiel V1a- V6b d'une borne B1a-B6b d'une cellule B1-B6 et le potentiel de l'entrée U1-U7 correspondante du convertisseur analogique-numérique ADC.

Pour ce faire, l'unité de contrôle UC comprend une pluralité de ponts diviseurs de tension P1-P7, chacun étant disposé entre une borne B1a-B6b d'une cellule B1-B6 et une entrée EN1-EN7 correspondante. Chaque pont diviseur de tension P1-P7 comprend de préférence deux résistances dont une est reliée à une masse MA de l'unité de contrôle UC.

Le dispositif de gestion de fonctionnement de batterie DGF comprend également un dispositif d'équilibrage à courant de fuite R pourvu d'une pluralité de résistance R1-R6, chacune étant connectée en parallèle d'une cellule B1-B6 correspondante. Les résistances R1-R6 sont disposées entre les cellules B1-B6 et les ponts diviseurs de tension P1-P7.

Lorsque le dispositif de gestion de fonctionnement de batterie DGF est raccordée à la batterie B, il est agencé pour mettre en œuvre un procédé de gestion de fonctionnement de batterie pendant la charge et également pendant la décharge.

Comme également illustré à la figure 2, le procédé de gestion de fonctionnement de batterie comprend une étape préalable E0 de détermination du nombre de cellules B1-B6 de la batterie B. En effet, les paramètres de calibration PC1-PC7 sont fonction du nombre de cellules B1-B6. Ceci permet de déterminer quel type de batterie est utilisé.

Une première étape E1 du procédé de gestion de fonctionnement de batterie consiste en la collecte par le microcontrôleur C de signaux de sortie SS1-SS7, chacun étant disponible sur l'au moins une sortie S du convertisseur analogique-numérique ADC. Le microcontrôleur C est agencé pour lire les signaux de sortie SS1-SS7 par multiplexage.

Chaque signal de sortie SS1-SS7 donne une valeur représentative VR1-VR7 d'un potentiel U1-U7 de l'entrée EN1-EN7 correspondante du convertisseur analogique-numérique ADC.

Une deuxième étape E2 consiste, pour chaque signal de sortie SS1-SS7, en la lecture de paramètres de calibration PC1-PC7 dans la mémoire M de l'unité de contrôle UC.

Les paramètres de calibration PC1-PC7 dépendent de caractéristiques intrinsèques d'une part de la branche de circuit BR1-BR7 correspondante et d'autre part du convertisseur analogique-numérique ADC.

Les paramètres de calibration PC1-PC7 sont chacun relatif à une branche de circuit BR1-BR7 correspondante et au convertisseur analogique-numérique ADC. Ils comprennent chacun une valeur de décalage en tension et une valeur de gain en tension.

Une troisième étape E3 consiste en l'obtention, à partir de chaque valeur représentative VR1-VR7, d'une valeur représentative corrigée VR1corr-VR7corr par correction de la valeur représentative VR1 collectée en prenant en compte les paramètres de calibration PC1-PC7 correspondants.

Chaque valeur représentative corrigée VR1cor-VR7corr correspond à une valeur calculée d'un potentiel V1a-V6b de la borne B1a-B6b correspondante d'une cellule B1-B6.

Une quatrième étape E4 consiste en la détermination, pour chaque cellule B1-B6, d'une valeur de tension calculée UR1-UR6 aux bornes B1a-B6b de la cellule B1-B6 correspondante.

Ladite détermination prend en compte les valeurs représentatives corrigées VR1corr-VR7corr correspondant aux bornes B1a-B6b de ladite cellule B1-B6.

Lorsque le procédé de gestion de fonctionnement de batterie est mis en œuvre pendant la charge de la batterie, le procédé comprend en outre une étape EC1 de comparaison de chaque valeur de tension calculée UR1-UR6 à une valeur de tension limite prédéterminée correspondante, cette dernière étant relative aux caractéristiques de la cellule B1-B6 correspondante.

Une étape EC2 consiste ensuite en l'arrêt de la charge de la batterie par le dispositif de gestion de fonctionnement DGF lorsqu'au moins une des valeurs de tension calculée UR1-UR6 est supérieure à la valeur de tension limite prédéterminée correspondante.

Lorsque le procédé de gestion de fonctionnement de batterie est mis en œuvre pendant la décharge de la batterie, le procédé comprend en outre une étape ED1 de comparaison de chaque valeur de tension calculée UR1-UR6 à une valeur de tension minimale de fonctionnement prédéterminée correspondante, cette dernière étant relative aux caractéristiques de la cellule B1-B6 correspondante.

Une étape ED2 consiste ensuite en la génération d'un signal de fin de décharge par le dispositif de gestion de fonctionnement DGF lorsqu'au moins une des valeurs de tension calculée UR1-UR6 est inférieure à la valeur de tension de fonctionnement minimale prédéterminée correspondante.

Le procédé de gestion de fonctionnement de batterie comprend également une phase de calibration préalable à l'étape E2 de lecture de paramètres de calibration PC1-PC7 dans la mémoire M de l'unité de contrôle UC.

Il s'agit d'un étalonnage réalisé en usine pour déterminer et enregistrer en mémoire M les paramètres de calibration PC1-PC7.

Une étape EP0 de sélection et d'enregistrement en mémoire de l'unité de contrôle UC du nombre de cellules B1-B6 de la batterie B est tout d'abord réalisée.

Une étape EP1 consiste ensuite en l'application simultanée, à chaque borne B1a-B6b de cellule B1-B6, de valeurs de potentiels de référence en lieu et place des cellules B1-B6.

Ainsi, pendant cette étape, la batterie B n'est pas connectée au dispositif de gestion de fonctionnement de batterie DGF. Typiquement, il s'agit d'appliquer une tension maximale de charge et d'une tension minimale de décharge aux bornes B1a-B6b de chaque cellule B1-B6.

Une étape EP2 consiste en la collecte par le microcontrôleur C d'une pluralité de signaux de sortie SS1-SS7 de calibration du convertisseur analogique-numérique ADC.

Chaque signal de sortie donne une valeur représentative VR1-VR7 d'un potentiel U1-U7 sur l'entrée correspondante du convertisseur analogique-numérique ADC.

Une étape EP3 consiste en la détermination des paramètres de calibration PC1-PC7 en fonction des valeurs de potentiels de référence et de signaux de sortie SS1-SS7 de calibration correspondants.

Enfin une étape EP4 consiste en l'enregistrement en mémoire M des paramètres de calibration PC1-PC7.

Les étapes du procédé de gestion de fonctionnement de batterie EP0, EP1, EP2, EP3 et EP4 peuvent être réalisées à plusieurs reprises pour des batteries B de différents nombres de cellules B1-B6.

Il apparait ainsi que la phase de calibration préalable et l'enregistrement en mémoire M des paramètres de calibration PC1-PC6 permettent au microcontrôleur C de déterminer avec précision les tensions calculées UR1-UR6 des cellules B1-B6.

Le dispositif de gestion de fonctionnement de batterie DGF est de constitution simple, ce qui permet de réaliser aisément un dispositif fiable et à moindre coût.

Egalement, plusieurs types de batteries B avec différents nombres de cellules B1-B6 peuvent être utilisés. En effet, l'étalonnage du dispositif de gestion de fonctionnement de batterie DGF permet de s'adapter à la configuration de la batterie B.

L'utilisation d'un convertisseur analogique-numérique ne pose pas de problème pour l'exactitude des signaux de sorties du fait de la calibration préalable.

Ainsi, la calibration permet de s'affranchir de cette contrainte de dispersion de caractéristiques.

Comme il va de soi, l'invention ne se limite pas à la seule forme d'exécution décrite ci-dessus à titre d'exemple, elle en embrasse au contraire toutes les variantes de réalisation.

## Revendications

1. Procédé de gestion de fonctionnement de batterie pour une charge et/ou une décharge d'une batterie (B), la batterie (B) comprenant une pluralité de cellules (B1-B6), le procédé étant mis en œuvre par une unité de contrôle (UC), l'unité de contrôle (UC) comprenant un microcontrôleur (C), une mémoire (M) associée au microcontrôleur (C) et un convertisseur analogique-numérique (ADC), le convertisseur analogique-numérique (ADC) comprenant des entrées (EN1-EN7), chaque entrée (EN1-EN7) étant reliée à une branche de circuit (BR1-BR7) comprenant un pont diviseur de tension (P1-P7) dont une borne est reliée à la masse de l'unité de contrôle (UC) et connectant ladite entrée (EN1-EN7) à une borne (B1a-B6b) d'une cellule (B1-B6) de la batterie (B), le convertisseur analogique-numérique (ADC) comprenant au moins une sortie (S), l'au moins une sortie (S) étant configurée pour délivrer une pluralité de signaux de sortie (SS1-SS7) correspondant à chacune des entrées (EN1-EN7), le procédé comprenant des étapes suivantes :
- (E1) collecte par le microcontrôleur (C) d'une pluralité de signaux de sortie (SS1-SS7) du convertisseur analogique-numérique (ADC), chaque signal de sortie (SS1-SS7) donnant une valeur représentative (VR1-VR7) d'un potentiel (U1-U7) de l'entrée (EN1-EN7) correspondante du convertisseur analogique-numérique (ADC),
- (E2) pour chaque signal de sortie (SS1-SS7), lecture de paramètres de calibration (PC1-PC7) dans la mémoire (M) de l'unité de contrôle (UC), les paramètres de calibration (PC1-PC7) dépendant de caractéristiques intrinsèques d'une part de la branche de circuit (BR1-BR7) correspondante et d'autre part du convertisseur analogique-numérique (ADC), le convertisseur analogique-numérique (ADC) reliant lesdites entrées (EN1-EN7) à l'au moins une sortie (S) du convertisseur analogique-numérique (ADC),
- (E3) obtention, à partir de chaque valeur représentative (VR1-VR7), d'une valeur représentative corrigée (VR1corr-VR7corr) par correction de la valeur représentative (VR1) collectée en prenant en compte les paramètres de calibration (PC1-PC7) correspondants, la valeur représentative corrigée (VR1corr-VR7corr) correspondant à une valeur calculée d'un potentiel (V1a-V6b) de la borne (B1a-B6b) correspondante de la cellule (B1-B6),
- (E4) détermination, pour chaque cellule (B1-B6), d'une valeur de tension calculée (UR1-UR6) aux bornes (B1a-B6b) de la cellule (B1-B6) correspondante, ladite détermination prenant en compte les valeurs représentatives corrigées (VR1corr-VR7corr) correspondant aux bornes (B1a-B6b) de ladite cellule (B1-B6).

2. Procédé de gestion de fonctionnement de batterie selon la revendication 1, dans lequel les cellules (B1-B6) sont raccordées électriquement en série et le convertisseur analogique-numérique (ADC) comprend plusieurs entrées (EN1-EN7), deux entrées (EN1-EN7) consécutives correspondant aux deux bornes d'une cellule (B1-B6), au moins une entrée (EN2-EN6) desdites deux entrées (EN1-EN7) correspondant à une borne commune à deux cellules (B1-B6) attenantes.

3. Procédé de gestion de fonctionnement de batterie selon la revendication 2, dans lequel, lors de la charge de la batterie, les étapes suivantes sont également réalisées :
- (EC1) comparaison des valeurs de tensions calculées (UR1-UR6) relatives aux cellules (B1-B6) à au moins une valeur de tension limite prédéterminée correspondante,
- (EC2) génération par l'unité de commande (UC) d'un signal de d'arrêt de la charge de la batterie lorsqu'au moins une des valeurs de tension calculée (UR1-UR6) atteint l'au moins une valeur de tension limite prédéterminée correspondante.

4. Procédé de gestion de fonctionnement de batterie selon l'une des revendications 2 ou 3, dans lequel, lors de la décharge de la batterie, les étapes suivantes sont également réalisées :
- (ED1) comparaison des valeurs de tensions calculées (UR1-UR6) relatives aux cellules (B1-B6) à au moins une valeur de tension minimale de fonctionnement prédéterminée correspondante,
- (ED2) génération par l'unité de commande (UC) d'un signal d'arrêt de décharge de la batterie lorsqu'au moins une valeur de tension calculée (UR1-UR6) atteint l'au moins une valeur de tension minimale de fonctionnement prédéterminée correspondante.

5. Procédé de gestion de fonctionnement de batterie selon l'une des revendications 1 à 4, dans lequel les paramètres de calibration (PC1) prennent en compte un facteur de division (FD1-FD7) entre le potentiel (V1a- V6b) d'une borne (B1a-B6b) d'une cellule (B1-B6) et le potentiel de l'entrée (U1-U7) correspondante du convertisseur analogique-numérique (ADC).

6. Procédé de gestion de fonctionnement de batterie selon l'une des revendications 1 à 5, dans lequel un dispositif d'équilibrage à courant de fuite (R) provoque des courants de fuite entre les cellules (B1-B6) de façon à équilibrer les courants circulant dans chaque cellule (B1-B6), le dispositif d'équilibrage à courant de fuite (R) comprenant une pluralité de résistances (R1-R6), chaque résistance (R1-R6) étant connectée parallèlement à une cellule (B1-B6) correspondante.

7. Procédé de gestion de fonctionnement de batterie selon l'une des revendications 1 à 6, comprenant une étape préalable (E0) de détermination du nombre de cellules (B1-B6) de la batterie (B), les paramètres de calibration (PC1-PC7) étant fonction du nombre de cellules (B1-B6).

8. Procédé de gestion de fonctionnement de batterie selon l'une des revendications 1 à 7, dans lequel les paramètres de calibration (PC1) sont déterminés lors d'une phase de calibration préalable à l'étape (E2) de lecture relative à la branche de circuit (BR1) correspondante, la phase de calibration préalable comprenant les étapes suivantes :
- (EP1) application de valeurs de potentiels de référence en lieu et place des bornes (B1a-B6b) des cellules (B1-B6),
- (EP2) collecte par le microcontrôleur (C) d'une pluralité de signaux de sortie (SS1-SS7) de calibration du convertisseur analogique-numérique (ADC), chaque signal de sortie donnant une valeur représentative (VR1-VR7) d'un potentiel (U1-U7) sur l'entrée correspondante du convertisseur analogique-numérique (ADC),
- (EP3) détermination des paramètres de calibration (PC1-PC7) en fonction des valeurs de potentiels de référence et de signaux de sortie (SS1-SS7) de calibration correspondants.

9. Procédé de gestion de fonctionnement de batterie selon la revendication 8, dans lequel, pour chaque entrée (EN1-EN7), l'étape (EP1) d'application d'une valeur de potentiel de référence et l'étape (EP2) de collecte par le microcontrôleur (C) d'un signal de sortie de calibration correspondant sont réalisés deux fois de façon à obtenir un premier signal de sortie de calibration et un deuxième signal de sortie de calibration par entrée (EN1-EN7) en fonction, respectivement, d'une première valeur de potentiel de référence et d'une deuxième valeur de potentiel de référence et dans lequel l'étape (EP3) de détermination des paramètres de calibration prend en compte, pour chaque entrée (EN1-EN7), le premier signal de sortie de calibration et le deuxième signal de sortie de calibration relativement à la première valeur de potentiel de référence et la deuxième valeur de potentiel de référence.

10. Procédé de gestion de fonctionnement de batterie selon la revendication 9, dans lequel la première valeur de potentiel de référence correspond à une tension maximale de charge et la deuxième valeur de potentiel de référence correspond à une tension minimale de décharge.

11. Procédé de gestion de fonctionnement de batterie selon l'une des revendications 9 ou 10, dans lequel les paramètres de calibration comprennent une valeur de décalage en tension et une valeur de gain en tension.

12. Procédé de gestion de fonctionnement de batterie selon l'une des revendications 8 à 11, comprenant une étape (EP0) de sélection et d'enregistrement en mémoire de l'unité de contrôle (UC) du nombre de cellules (B1-B6) de la batterie (B).

13. Procédé de gestion de fonctionnement de batterie selon la revendication 12, dans lequel les étapes dudit procédé (EP0, EP1, EP2, EP3) sont réalisées à plusieurs reprises pour des batteries (B) de nombres différents de cellules (B1-B6).

14. Dispositif de gestion de fonctionnement de batterie (DGF) pour surveiller une charge et/ou une décharge d'une batterie (B) comprenant une pluralité de cellules (B1-B6) configuré pour exécuter un procédé de gestion selon l'une des revendications 1 à 13.

## Patentansprüche

1. Verfahren zur Verwaltung des Betriebs einer Batterie zum Laden und/oder Entladen einer Batterie (B), wobei die Batterie (B) eine Vielzahl von Zellen (B1-B6) umfasst, wobei das Verfahren durch eine Kontrolleinheit (UC) durchgeführt wird, wobei die Kontrolleinheit (UC) einen Mikrocontroller (C), einen dem Mikrocontroller (C) zugeordneten Speicher (M) und einen Analog-Digital-Wandler (ADC) umfasst, wobei der Analog-Digital-Wandler (ADC) Eingänge (EN1-EN7) umfasst, wobei jeder Eingang (EN1-EN7) mit einem Schaltungszweig (BR1-BR7) verbunden ist, der einen Spannungsteiler (P1-P7) umfasst, dessen einer Anschluss mit der Masse der Kontrolleinheit (UC) verbunden ist, und der den Eingang (EN1-EN7) mit einem Anschluss (B1a-B6b) einer Zelle (B1-B6) der Batterie (B) verbindet, wobei der Analog-Digital-Wandler (ADC) mindestens einen Ausgang (S) umfasst, wobei der mindestens eine Ausgang (S) dazu eingerichtet ist, eine Vielzahl von Ausgangssignalen (SS1-SS7) abzugeben, die jeweils einem der Eingänge (EN1-EN7) entsprechen, wobei das Verfahren folgende Schritte umfasst:
- (E1) Erfassen einer Vielzahl von Ausgangssignalen (SS1-SS7) des Analog-Digital-Wandlers (ADC) durch den Mikrocontroller (C), wobei jedes Ausgangssignal (SS1-SS7) einen repräsentativen Wert (VR1-VR7) eines Potentials (U1-U7) des entsprechenden Eingangs (EN1-EN7) des Analog-Digital-Wandlers (ADC) liefert,
- (E2) für jedes Ausgangssignal (SS1-SS7), Auslesen von Kalibrierparametern (PC1-PC7) aus dem Speicher (M) der Kontrolleinheit (UC), wobei die Kalibrierparameter (PC1-PC7) von intrinsischen Eigenschaften einerseits des entsprechenden Schaltungszweigs (BR1-BR7) und andererseits des Analog-Digital-Wandlers (ADC) abhängen, wobei der Analog-Digital-Wandler (ADC) die Eingänge (EN1-EN7) mit dem mindestens einen Ausgang (S) des Analog-Digital-Wandlers (ADC) verbindet,
- (E3) Erhalten eines korrigierten repräsentativen Werts (VR1corr-VR7corr) aus jedem repräsentativen Wert (VR1-VR7) durch Korrektur des erfassten repräsentativen Werts (VR1) unter Berücksichtigung der entsprechenden Kalibrierparameter (PC1-PC7), wobei der korrigierte repräsentative Wert (VR1corr-VR7corr) einem berechneten Wert eines Potentials (V1a-V6b) des entsprechenden Anschlusses (B1a-B6b) der Zelle (B1-B6) entspricht,
- (E4) Bestimmen eines berechneten Spannungswerts (UR1-UR6) an den Anschlüssen (B1a-B6b) der entsprechenden Zelle (B1-B6) für jede Zelle (B1-B6), wobei bei dieser Bestimmung die korrigierten repräsentativen Werte (VR1corr-VR7corr) berücksichtigt werden, die den Anschlüssen (B1aB6b) dieser Zelle (B1-B6) entsprechen.

2. Verfahren zur Verwaltung des Betriebs einer Batterie nach Anspruch 1, wobei die Zellen (B1-B6) elektrisch in Reihe geschaltet sind und der Analog-Digital-Wandler (ADC) mehrere Eingänge (EN1-EN7) umfasst, wobei zwei aufeinanderfolgende Eingänge (EN1-EN7) den beiden Anschlüssen einer Zelle (B1-B6) entsprechen, wobei mindestens ein Eingang (EN2-EN6) der beiden Eingänge (EN1-EN7) einem gemeinsamen Anschluss zweier benachbarter Zellen (B1-B6) entspricht.

3. Verfahren zur Verwaltung des Betriebs einer Batterie nach Anspruch 2, wobei beim Laden der Batterie auch die folgenden Schritte durchgeführt werden:
- (EC1) Vergleichen der auf die Zellen (B1-B6) bezogenen berechneten Spannungswerte (UR1-UR6) mit mindestens einem entsprechenden vorbestimmten Grenzspannungswert,
- (EC2) Erzeugen eines Signals zum Beenden des Ladens der Batterie durch die Steuereinheit (UC), wenn mindestens einer der berechneten Spannungswerte (UR1-UR6) den mindestens einen entsprechenden vorbestimmten Grenzspannungswert erreicht.

4. Verfahren zur Verwaltung des Betriebs einer Batterie nach einem der Ansprüche 2 oder 3, wobei beim Entladen der Batterie auch die folgenden Schritte durchgeführt werden:
- (ED1) Vergleichen der auf die Zellen (B1-B6) bezogenen berechneten Spannungswerte (UR1-UR6) mit mindestens einem entsprechenden vorbestimmten Mindestbetriebsspannungswert,
- (ED2) Erzeugen eines Signals zum Beenden des Entladens der Batterie durch die Steuereinheit (UC), wenn mindestens ein berechneter Spannungswert (UR1-UR6) den mindestens einen entsprechenden vorbestimmten Mindestbetriebsspannungswert erreicht.

5. Verfahren zur Verwaltung des Betriebs einer Batterie nach einem der Ansprüche 1 bis 4, wobei die Kalibrierparameter (PC1) einen Teilungsfaktor (FD1-FD7) zwischen dem Potential (V1a- V6b) eines Anschlusses (B1a-B6b) einer Zelle (B1-B6) und dem Potential des entsprechenden Eingangs (U1-U7) des Analog-Digital-Wandlers (ADC) berücksichtigen.

6. Verfahren zur Verwaltung des Betriebs einer Batterie nach einem der Ansprüche 1 bis 5, wobei eine Leckstrom-Ausgleichsvorrichtung (R) Leckströme zwischen den Zellen (B1-B6) hervorruft, um die in jeder Zelle (B1-B6) fließenden Ströme auszugleichen, wobei die Leckstrom-Ausgleichsvorrichtung (R) eine Vielzahl von Widerständen (R1-R6) umfasst, wobei jeder Widerstand (R1-R6) parallel zu einer entsprechenden Zelle (B1-B6) geschaltet ist.

7. Verfahren zur Verwaltung des Betriebs einer Batterie nach einem der Ansprüche 1 bis 6, umfassend einen vorhergehenden Schritt (E0) des Bestimmens der Anzahl der Zellen (B1-B6) der Batterie (B), wobei die Kalibrierparameter (PC1-PC7) von der Anzahl der Zellen (B1-B6) abhängen.

8. Verfahren zur Verwaltung des Betriebs einer Batterie nach einem der Ansprüche 1 bis 7, wobei die Kalibrierparameter (PC1) während einer dem Ausleseschritt (E2) bezüglich des entsprechenden Schaltungszweigs (BR1) vorausgehenden Kalibrierphase bestimmt werden, wobei die vorausgehende Kalibrierphase die folgenden Schritte umfasst:
- (EP1) Anlegen von Referenzpotentialwerten anstelle der Anschlüsse (B1aB6b) der Zellen (B1-B6),
- (EP2) Erfassen einer Vielzahl von Kalibrierausgangssignalen (SS1-SS7) des Analog-Digital-Wandlers (ADC) durch den Mikrocontroller (C), wobei jedes Ausgangssignal einen repräsentativen Wert (VR1-VR7) eines Potentials (U1-U7) am entsprechenden Eingang des Analog-Digital-Wandlers (ADC) liefert,
- (EP3) Bestimmen der Kalibrierparameter (PC1-PC7) in Abhängigkeit von den Referenzpotentialwerten und den entsprechenden Kalibrierausgangssignalen (SS1-SS7).

9. Verfahren zur Verwaltung des Betriebs einer Batterie nach Anspruch 8, wobei für jeden Eingang (EN1-EN7) der Schritt (EP1) des Anlegens eines Referenzpotentialwerts und der Schritt (EP2) des Erfassens eines entsprechenden Kalibrierausgangssignals durch den Mikrocontroller (C) zweimal durchgeführt werden, um ein erstes Kalibrierausgangssignal und ein zweites Kalibrierausgangssignal pro Eingang (EN1-EN7) in Abhängigkeit von einem ersten Referenzpotentialwert beziehungsweise einem zweiten Referenzpotentialwert zu erhalten, und wobei der Schritt (EP3) des Bestimmens der Kalibrierparameter für jeden Eingang (EN1-EN7) das erste Kalibrierausgangssignal und das zweite Kalibrierausgangssignal in Bezug auf den ersten Referenzpotentialwert und den zweiten Referenzpotentialwert berücksichtigt.

10. Verfahren zur Verwaltung des Betriebs einer Batterie nach Anspruch 9, wobei der erste Referenzpotentialwert einer maximalen Ladespannung entspricht und der zweite Referenzpotentialwert einer minimalen Entladespannung entspricht.

11. Verfahren zur Verwaltung des Betriebs einer Batterie nach einem der Ansprüche 9 oder 10, wobei die Kalibrierparameter einen Spannungsoffsetwert und einen Spannungsverstärkungswert umfassen.

12. Verfahren zur Verwaltung des Betriebs einer Batterie nach einem der Ansprüche 8 bis 11, umfassend einen Schritt (EP0) des Auswählens und des Speicherns der Anzahl der Zellen (B1-B6) der Batterie (B) im Speicher der Kontrolleinheit (UC).

13. Verfahren zur Verwaltung des Betriebs einer Batterie nach Anspruch 12, wobei die Schritte dieses Verfahrens (EP0, EP1, EP2, EP3) für Batterien (B) mit unterschiedlichen Anzahlen von Zellen (B1-B6) mehrmals durchgeführt werden.

14. Vorrichtung zur Verwaltung des Betriebs einer Batterie (DGF) zum Überwachen eines Ladens und/oder eines Entladens einer Batterie (B), die eine Vielzahl von Zellen (B1-B6) umfasst, wobei die Vorrichtung dazu eingerichtet ist, ein Verwaltungsverfahren nach einem der Ansprüche 1 bis 13 auszuführen.

## Claims

1. Method for managing the operation of a battery for charging and/or discharging a battery (B), the battery (B) comprising a plurality of cells (B1-B6), the method being implemented by a control unit (UC), the control unit (UC) comprising a microcontroller (C), a memory (M) associated with the microcontroller (C) and an analogue-to-digital converter (ADC), the analogue-to-digital converter (ADC) comprising inputs (EN1-EN7), each input (EN1-EN7) being connected to a circuit branch (BR1-BR7) comprising a voltage divider (P1-P7) having one terminal connected to the ground of the control unit (UC) and connecting said input (EN1-EN7) to a terminal (B1a-B6b) of a cell (B1-B6) of the battery (B), the analogue-to-digital converter (ADC) comprising at least one output (S), the at least one output (S) being configured to deliver a plurality of output signals (SS1-SS7) corresponding to each of the inputs (EN1-EN7), the method comprising the following steps:
- (E1) collecting, by the microcontroller (C), a plurality of output signals (SS1-SS7) from the analogue-to-digital converter (ADC), each output signal (SS1-SS7) providing a representative value (VR1-VR7) of a potential (U1-U7) of the corresponding input (EN1-EN7) of the analogue-to-digital converter (ADC),
- (E2) for each output signal (SS1-SS7), reading calibration parameters (PC1-PC7) in the memory (M) of the control unit (UC), the calibration parameters (PC1-PC7) depending on intrinsic characteristics of, on the one hand, the corresponding circuit branch (BR1-BR7) and, on the other hand, the analogue-to-digital converter (ADC), the analogue-to-digital converter (ADC) connecting said inputs (EN1-EN7) to the at least one output (S) of the analogue-to-digital converter (ADC),
- (E3) obtaining, from each representative value (VR1-VR7), a corrected representative value (VR1corr-VR7corr) by correcting the collected representative value (VR1) taking into account the corresponding calibration parameters (PC1-PC7), the corrected representative value (VR1corr-VR7corr) corresponding to a calculated value of a potential (V1a-V6b) of the corresponding terminal (B1a-B6b) of the cell (B1-B6),
- (E4) determining, for each cell (B1-B6), a calculated voltage value (UR1-UR6) across the terminals (B1a-B6b) of the corresponding cell (B1-B6), said determination taking into account the corrected representative values (VR1corr-VR7corr) corresponding to the terminals (B1a-B6b) of said cell (B1-B6).

2. Method for managing the operation of a battery according to claim 1, wherein the cells (B1-B6) are electrically connected in series and the analogue-to-digital converter (ADC) comprises several inputs (EN1-EN7), two consecutive inputs (EN1-EN7) corresponding to the two terminals of a cell (B1-B6), at least one input (EN2-EN6) of said two inputs (EN1-EN7) corresponding to a terminal common to two adjacent cells (B1-B6).

3. Method for managing the operation of a battery according to claim 2, wherein, during charging of the battery, the following steps are also carried out:
- (EC1) comparing the calculated voltage values (UR1-UR6) relating to the cells (B1-B6) with at least one corresponding predetermined limit voltage value,
- (EC2) generating, by the control unit (UC), a signal for stopping charging of the battery when at least one of the calculated voltage values (UR1-UR6) reaches the at least one corresponding predetermined limit voltage value.

4. Method for managing the operation of a battery according to either of claims 2 or 3, wherein, during discharging of the battery, the following steps are also carried out:
- (ED1) comparing the calculated voltage values (UR1-UR6) relating to the cells (B1-B6) with at least one corresponding predetermined minimum operating voltage value,
- (ED2) generating, by the control unit (UC), a signal for stopping discharging of the battery when at least one calculated voltage value (UR1-UR6) reaches the at least one corresponding predetermined minimum operating voltage value.

5. Method for managing the operation of a battery according to any one of claims 1 to 4, wherein the calibration parameters (PC1) take into account a division factor (FD1-FD7) between the potential (V1a- V6b) of a terminal (B1a-B6b) of a cell (B1-B6) and the potential of the corresponding input (U1-U7) of the analogue-to-digital converter (ADC).

6. Method for managing the operation of a battery according to any one of claims 1 to 5, wherein a leakage-current balancing device (R) causes leakage currents between the cells (B1-B6) so as to balance the currents flowing through each cell (B1-B6), the leakage-current balancing device (R) comprising a plurality of resistors (R1-R6), each resistor (R1-R6) being connected in parallel with a corresponding cell (B1-B6).

7. Method for managing the operation of a battery according to any one of claims 1 to 6, comprising a preliminary step (E0) of determining the number of cells (B1-B6) of the battery (B), the calibration parameters (PC1-PC7) being a function of the number of cells (B1-B6).

8. Method for managing the operation of a battery according to any one of claims 1 to 7, wherein the calibration parameters (PC1) are determined during a calibration phase prior to the reading step (E2) relating to the corresponding circuit branch (BR1), the preliminary calibration phase comprising the following steps:
- (EP1) applying reference potential values in place of the terminals (B1a-B6b) of the cells (B1-B6),
- (EP2) collecting, by the microcontroller (C), a plurality of calibration output signals (SS1-SS7) from the analogue-to-digital converter (ADC), each output signal providing a representative value (VR1-VR7) of a potential (U1-U7) at the corresponding input of the analogue-to-digital converter (ADC),
- (EP3) determining the calibration parameters (PC1-PC7) as a function of the reference potential values and the corresponding calibration output signals (SS1-SS7).

9. Method for managing the operation of a battery according to claim 8, wherein, for each input (EN1-EN7), the step (EP1) of applying a reference potential value and the step (EP2) of collecting, by the microcontroller (C), a corresponding calibration output signal are carried out twice so as to obtain a first calibration output signal and a second calibration output signal per input (EN1-EN7) as a function, respectively, of a first reference potential value and a second reference potential value and wherein the step (EP3) of determining the calibration parameters takes into account, for each input (EN1-EN7), the first calibration output signal and the second calibration output signal in relation to the first reference potential value and the second reference potential value.

10. Method for managing the operation of a battery according to claim 9, wherein the first reference potential value corresponds to a maximum charging voltage and the second reference potential value corresponds to a minimum discharging voltage.

11. Method for managing the operation of a battery according to either of claims 9 or 10, wherein the calibration parameters comprise a voltage offset value and a voltage gain value.

12. Method for managing the operation of a battery according to any one of claims 8 to 11, comprising a step (EP0) of selecting and storing in the memory of the control unit (UC) the number of cells (B1-B6) of the battery (B).

13. Method for managing the operation of a battery according to claim 12, wherein the steps of said method (EP0, EP1, EP2, EP3) are carried out repeatedly for batteries (B) having different numbers of cells (B1-B6).

14. Device for managing the operation of a battery (DGF) for monitoring charging and/or discharging of a battery (B) comprising a plurality of cells (B1-B6), configured to carry out a management method according to any one of claims 1 to 13.
